(19) Europäisches Patentamt
European Patent Office
Office européen des brevets

(11) EP 4 782 479 A1

(12) **EUROPEAN PATENT APPLICATION**
published in accordance with Art. 153(4) EPC

(43) Date of publication:
**29.07.2026 Bulletin 2026/31**

(21) Application number: **24867982.1**

(22) Date of filing: **16.08.2024**

(51) International Patent Classification (IPC):
***C08J 3/12*** *(2006.01)* ***C08F 212/00*** *(2006.01)*
***C08F 255/00*** *(2006.01)* ***C09D 7/65*** *(2018.01)*
***C09D 201/00*** *(2006.01)* ***H01L 23/29*** *(2006.01)*
***H01L 23/31*** *(2006.01)*

(52) Cooperative Patent Classification (CPC):
**C08F 212/00; C08F 255/00; C08J 3/12; C09D 7/65; C09D 201/00; H10W 74/10; H10W 74/40**

(86) International application number:
**PCT/JP2024/029223**

(87) International publication number:
**WO 2025/062901 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.09.2023 JP 2023150759**

(71) Applicant: **Sekisui Kasei Co., Ltd.**
**Kita-ku**
**Osaka-shi**
**Osaka 530-8565 (JP)**

(72) Inventor: **TAKAHASHI, Tomoyuki**
**Osaka-shi, Osaka 530-8565 (JP)**

(74) Representative: **Müller-Boré & Partner Patentanwälte PartG mbB**
**Friedenheimer Brücke 21**
**80639 München (DE)**

(54) **HOLLOW RESIN PARTICLES, USE THEREOF, AND METHOD FOR PRODUCING SAME**

(57) A hollow resin particle capable of exhibiting an excellent low dielectric characteristic and a uniform low dielectric characteristic is provided. Also, applications of such a hollow resin particle are provided. Furthermore, a method of manufacturing such a hollow resin particle is provided. The hollow resin particle according to an embodiment of the present invention is a hollow resin particle including: a shell portion and a hollow part surrounded by the shell portion, in which the amount of metal residue is equal to or less than 30 ppm, a dielectric loss tangent Df at a frequency of 10 GHz is equal to or less than 0.0050, and an F value which is an index of uniformity of the dielectric loss tangent Df is equal to or less than 0.30.

EP 4 782 479 A1

## Description

[Technical Field]

The present invention relates to a hollow resin particle, applications of the same, and a manufacturing method of the same.

[Background Art]

In recent years, mounting techniques such as high integration of semiconductor devices to be mounted, high density of wirings, and multilayering have been rapidly developed with increases in the amount of information processed by various electronic devices and communication speeds. Insulating resin materials for use in semiconductor members used in semiconductor devices are required to have low relative permittivity and low dielectric loss tangent in order to increase transmission speeds of high-frequency signals and reduce losses during signal transmission.

In response to such a requirement, a technique of introducing an air space into an insulating resin by mixing a hollow resin particle with a shell portion and a hollow part surrounded by the shell portion into the insulating resin to thereby achieve a low relative permittivity and a low dielectric loss tangent has been reported.

An acrylic hollow resin particle is known as one of hollow resin particles.

For example, it has been reported that an acrylic hollow resin particle can be obtained through suspension polymerization of monomers, mainly composed of acrylic polyfunctional monomers including trimethylolpropane tri(meth) acrylate and dipentaerythritol hexaacrylate, with a hydrophobic solvent (PTL 1).

However, the relative permittivity and dielectric loss tangent of the acrylic resin are high, which leads to degradation of a low dielectric characteristic. For this reason, the acrylic hollow resin particle described in PTL 1 cannot be applied to recent semiconductor devices that process high-frequency signals.

On the other hand, a styrene-based hollow resin particle is known as a hollow resin particle that has a lower dielectric characteristic than the acrylic hollow resin particle.

As the styrene-based hollow resin particle having a low dielectric characteristic, a hollow particle having a shell containing a resin and a hollow part surrounded by the shell, in which the resin in the shell is a polymer including 70 parts by mass to 100 parts by mass of crosslinkable monomer unit in 100 parts by mass of the total monomer unit, a porosity is equal to or greater than 60%, the content of a surfactant present on the surface of the hollow particle is equal to or less than 200 ppm, and relative permittivity at a frequency of 1 MHz is equal to or less than 1.6, has been reported (PTL 2).

The hollow particle reported in PTL 2 reduces surfactant residues by not using a surfactant in order to exhibit the effect. However, if hollow particles are manufactured without using a surfactant, aggregation or coalescence of particles may occur during the manufacturing, and particles out of specifications may be formed as by-products. If such particles out of specifications are produced as by-products, low dielectric characteristics may vary among the particles, and a problem that uniform low dielectric characteristics cannot be obtained may occur.

Furthermore, in the hollow particle reported in PTL 2, magnesium hydroxide colloid is used as a dispersion stabilizer instead of using a surfactant. However, if such a metal compound is used, the resulting hollow particle is likely to contain a large amount of metal residues. Also, the hollow particle with a large amount of metal residues may have a problem that low dielectric characteristics cannot be exhibited and uniform low dielectric characteristics cannot be exhibited. In addition, the large amount of metal residues can cause corrosion.

Furthermore, the hollow particle reported in PTL 2 is manufactured using a large amount of crosslinkable monomer, such as 70 parts by mass to 100 parts by mass of crosslinkable monomer unit (95.2 parts by mass or 91.9 parts by mass in examples) in 100 parts by mass of total monomer unit, thereby improving the strength of the shell. However, if a large amount of crosslinkable monomer is used, there may be a problem that unreacted crosslinking reactive sites remain and adversely affect the exhibition of low dielectric characteristics.

As another styrene-based hollow resin particle having a low dielectric characteristic, for example, a hollow resin particle having a shell portion and a hollow part surrounded by the shell portion, in which the total concentration of a specific metal element contained in the hollow resin particle is equal to or less than 200 mg/kg (200 ppm), has been reported (PTL 3).

The hollow resin particle reported in PTL 3 can exhibit an excellent low dielectric characteristic. However, it has been found that the hollow resin particle reported in PTL 3 cannot exhibit a uniform low dielectric characteristic even though it is manufactured using a surfactant, unlike the hollow particle reported in PTL 2.

[Citation List]

[Patent Literature]

[PTL 1] Japanese Patent No. 6513273
[PTL 2] WO 2022/107674
[PTL 3] Japanese Patent Application Publication No. 2022-96298

[Summary of Invention]

[Technical Problem]

An object of the present invention is to provide a hollow resin particle capable of exhibiting an excellent low dielectric characteristic and exhibiting a uniform low dielectric characteristic. Furthermore, another object of the present invention is to provide applications of such a hollow resin particle. In addition, yet another object of the present invention is to provide a method of manufacturing such a hollow resin particle.

[Solution to Problem]

[1] A hollow resin particle according to an embodiment of the present invention is a hollow resin particle including: a shell portion; and a hollow part surrounded by the shell portion, in which an amount of metal residue is equal to or less than 30 ppm, a dielectric loss tangent Df at a frequency of 10 GHz is equal to or less than 0.0050, and an F value which is an index of uniformity of the dielectric loss tangent Df is equal to or less than 0.30.
[2] In the hollow resin particle according to [1] above, the dielectric loss tangent Df may be equal to or less than 0.0030.
[3] In the hollow resin particle according to [1] or [2] above, the F value may be equal to or less than 0.15.
[4] In the hollow resin particle according to any one of [1] to [3] above, an average particle diameter may be 0.1 μm to 10.0 μm.
[5] In the hollow resin particle according to any one of [1] to [4] above, the shell portion may include an aromatic polymer (P1) obtained through a reaction of a monomer component (M) including an aromatic monofunctional monomer (a) and an aromatic crosslinkable monomer (b).
[6] In the hollow resin particle according to [5] above, a content proportion of aromatic polymer (P1) in the shell portion may be 60% by weight to 100% by weight.
[7] In the hollow resin particle according to [5] or [6] above, a content proportion of the aromatic crosslinkable monomer (b) in the monomer component (M) may be equal to or less than 60% by weight.
[8] In the hollow resin particle according to any one of [5] to [7] above, the monomer component (M) may include a hydrophilic monofunctional monomer (c).
[9] In the hollow resin particle according to [8] above, the hydrophilic monofunctional monomer (c) may be represented by General Formula (1) or General Formula (2),

[C1]

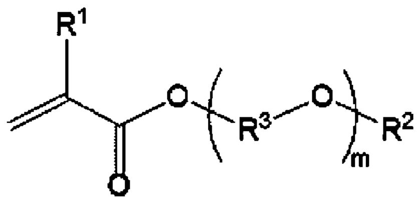

(1)

in General Formula (1), $R^1$ represents H or $CH_3$, $R^2$ represents H, an alkyl group, or a phenyl group, $R^3$ represents an alkanediyl group having 2 to 18 carbon atoms, m is an average number of addition moles of an oxyalkylene group represented by $R^3$-O and represents a number of 1 to 100, $R^3$, the number of which is m, are independent of each other,

[C2]

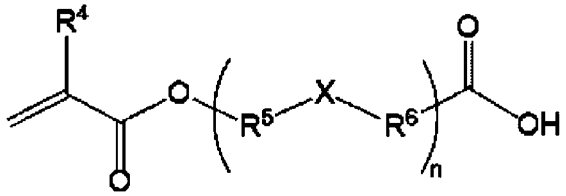

(2)

in General Formula (2), $R^4$ represents H or $CH_3$, $R^5$ represents an alkanediyl group having 1 to 10 carbon atoms or an alkenediyl group having 2 to 10 carbon atoms, $R^6$ represents a single bond, an alkanediyl group having 1 to 10 carbon atoms, an alkenediyl group having 2 to 10 carbon atoms, or a phenylene group, X represents a single bond, an ester bond, an ether bond, or a carbonyl group, n represents a number of 1 to 5, and $R^5$, the number of which is n, X, and $R^6$ are independent of each other.

[10] In the hollow resin particle according to any one of [5] to [9] above, the monomer component (M) may include a reactive surfactant (d) having a vinyl group.
[11] In the hollow resin particle according to [10] above, a content proportion of the reactive surfactant (d) having a vinyl group in the monomer component (M) may be 0.10% by weight to 1.0% by weight.
[12] In the hollow resin particle according to [11] above, a content proportion of the reactive surfactant (d) having a vinyl group in the monomer component (M) may be 0.10% by weight to 0.50% by weight.
[13] In the hollow resin particle according to any one of [10] to [12] above, the reactive surfactant (d) having a vinyl group may be an ammonium polyoxyethylene styrenated propenylphenyl ether sulfate ester.
[14] In the hollow resin particle according to any one of [1] to [13] above, the shell portion may include a non-crosslinkable polymer (P2).
[15] In the hollow resin particle according to [14] above, a content proportion of the non-crosslinkable polymer (P2) in the shell portion may be 0% by weight to 40% by weight.
[16] The hollow resin particle according to any one of [1] to [15] above may be used in a resin composition for a semiconductor member.
[17] The hollow resin particle according to any one of [1] to [15] above may be used in a paint composition.
[18] The hollow resin particle according to any one of [1] to [15] above may be used in a thermal insulation resin composition.
[19] The hollow resin particle according to any one of [1] to [15] above may be used in a light diffusion resin composition.
[20] The hollow resin particle according to any one of [1] to [15] above may be used in a light diffusion film.
[21] A resin composition for a semiconductor member according to an embodiment of the present invention includes: the hollow resin particle according to any one of [1] to [15] above.
[22] A paint composition according to an embodiment of the present invention includes: the hollow resin particle according to any one of [1] to [15] above.
[23] A thermal insulation resin composition according to an embodiment of the present invention includes: the hollow resin particle according to any one of [1] to [15] above.
[24] A light diffusion resin composition according to an embodiment of the present invention includes: the hollow resin particle according to any one of [1] to [15] above.
[25] A light diffusion film according to an embodiment of the present invention includes: the hollow resin particle according to any one of [1] to [15] above.
[26] A method of manufacturing a hollow resin particle according to an embodiment of the present invention is a method of manufacturing a hollow resin particle including a shell portion and a hollow part surrounded by the shell portion, the method including: preparing a suspension by mixing and stirring an oil phase and an aqueous phase and subjecting the suspension to suspension polymerization of a monomer component (M) contained in the suspension, in which the oil phase includes an aromatic monofunctional monomer (a) and an aromatic crosslinkable monomer (b), the aqueous phase includes a reactive surfactant (d) having a vinyl group, a content proportion of the aromatic monofunctional monomer (a) in the monomer component (M) is equal to or greater than 30% by weight, a content proportion of the aromatic crosslinkable monomer (b) in the monomer component (M) is equal to or less than 60% by weight, and a content proportion of the reactive surfactant (d) having a vinyl group in the monomer component (M) is 0.10% by weight to 1.0% by weight.

[Advantageous Effects of Invention]

According to an embodiment of the present invention, it is possible to provide a hollow resin particle capable of exhibiting an excellent low dielectric characteristic and exhibiting a uniform low dielectric characteristic. Furthermore, it is possible to provide an application of such a hollow resin particle. In addition, it is possible to provide a method of manufacturing such a hollow resin particle.

[Description of Embodiments]

Hereinafter, embodiments of the present invention will be described, but the present invention is not limited to these embodiments.

In the present specification, in a case where there is an expression "(meth)acrylic", the expression means "acrylic and/or methacrylic", and in a case where there is an expression "(meth)acrylate", the expression means "acrylate and/or methacrylate".

<<<<Hollow Resin Particle>>>>

A hollow resin particle according to an embodiment of the present invention is a hollow resin particle having a shell portion and a hollow part surrounded by the shell portion. The expression "hollow" mentioned herein means a state in which the interior is filled with a substance other than resins, for example, gas or liquid and preferably means a state in which the interior is filled with gas from the viewpoint of enabling the effect of the present invention to be further developed.

In the hollow resin particle of the embodiment of the present invention, the hollow part may be composed of one hollow region or may be composed of a plurality of hollow regions. It is preferable that the hollow part be composed of one hollow region from the viewpoint of a relatively large amount of resin component constituting the shell portion and preventing intrusion of a base material and the like into the hollow part.

The average particle diameter of the hollow resin particle according to the embodiment of the present invention is preferably 0.1 μm to 10.0 μm, is more preferably 0.1 μm to 5.0 μm, and is further preferably 0.2 μm to 4.0 μm. Depending on an application (in particular, a semiconductor member application) of the hollow resin particle, the average particle diameter of the hollow resin particle according to the embodiment of the present invention is further preferably 0.2 μm to 3.0 μm, is further preferably 0.2 μm to 2.0 μm, is further preferably 0.2 μm to 1.0 μm, is particularly preferably 0.2 μm to 0.8 μm, and is most preferably 0.2 μm to 0.6 μm. In a case where the average particle diameter of the hollow resin particle is less than 0.1 μm, the thickness of the shell portion becomes relatively thin, and there is thus a concern that the hollow resin particle may not have a sufficient strength. In a case where the average particle diameter of the hollow resin particle is larger than 10.0 μm, there is a concern that phase separation between a polymer generated by polymerization of a monomer component and a solvent may be less likely to occur during suspension polymerization, which creates another concern that formation of the shell portion may become difficult.

In the hollow resin particle according to the embodiment of the present invention, the amount of metal residue is typically equal to or less than 30 ppm. When the amount of the metal residue in the hollow resin particle exceeds 30 ppm, there are a concern that an excellent low dielectric characteristic cannot be exhibited and a concern that a uniform low dielectric characteristic cannot be exhibited. In addition, when the amount of the metal residue in the hollow resin particle exceeds 30 ppm, the metal residue may also cause corrosion.

In the hollow resin particle according to the embodiment of the present invention, a dielectric loss tangent Df at a frequency of 10 GHz is typically equal to or less than 0.0050, is preferably equal to or less than 0.0045, is more preferably equal to or less than 0.0040, is further preferably equal to or less than 0.0035, and is particularly preferably equal to or less than 0.0030. If the dielectric loss tangent Df at the frequency of 10 GHz falls within the above-described range, the hollow resin particle according to embodiments of the present invention can exhibit an excellent low dielectric characteristic.

In the hollow resin particle according to the embodiment of the present invention, an F value which is an index of uniformity of the dielectric loss tangent Df is typically equal to or less than 0.30, is preferably equal to or less than 0.25, is more preferably equal to or less than 0.20, is further preferably equal to or less than 0.15, and is particularly preferably equal to or less than 0.13. If the F value, which is an index of uniformity of the dielectric loss tangent Df, falls within the above-described range, the hollow resin particle according to the embodiment of the present invention can exhibit a uniform low dielectric characteristic.

The F value is an index of uniformity of the dielectric loss tangent Df and is a value calculated by measuring the dielectric loss tangent Df of the hollow resin particle at five measurement points, calculating the maximum value of Df ($Df_{max}$), the minimum value of Df ($Df_{min}$), and the average value of Df ($Df_{av}$), and calculating an expression of the F value = $(Df_{max} - Df_{min}) / Df_{av}$. A smaller F value means that variations in dielectric loss tangent Df are small and means that a uniform low dielectric characteristic can be exhibited.

<<Shell Portion>>

The shell portion preferably includes an aromatic polymer (P1).

From the viewpoint of enabling the effect of the present invention to be further exhibited, the content proportion of the aromatic polymer (P1) in the shell portion is preferably 60% by weight to 100% by weight, is more preferably 70% by weight to 100% by weight, and is further preferably 80% by weight to 100% by weight.

Typically, the aromatic polymer (P1) is obtained through a reaction of a monomer component (M) including an aromatic monofunctional monomer (a) and an aromatic crosslinkable monomer (b). The effect of the present invention may be further exhibited by the shell portion including such an aromatic polymer (P1) obtained through the reaction of the monomer component including the aromatic monofunctional monomer (a) and the aromatic crosslinkable monomer (b).

The aromatic polymer (P1) can be defined as being obtained through a reaction of the monomer component (M) as described above. This indicates that since the aromatic polymer (P1) is obtained as the aromatic polymer (P1) through the reaction of the monomer component (M), it is impossible to directly specify the aromatic polymer (P1) by the structure thereof, and there is a substantially impractical circumstance ("impossible/impractical circumstance"), the aromatic polymer (P1) is reasonably defined as a "substance" by the definition of "being obtained through a reaction of the monomer component (M) ".

From the viewpoint of enabling the effect of the present invention to be further exhibited, the content proportion of the aromatic monofunctional monomer (a) in the monomer component (M) is preferably equal to or greater than 30% by weight, is more preferably 30% by weight to 80% by weight, is further preferably 35% by weight to 70% by weight, and is particularly preferably 40% by weight to 60% by weight. If the content proportion of the aromatic monofunctional monomer (a) in the monomer component (M) falls within the above-described range, it is possible to cause the effect of the present invention to be further exhibited.

From the viewpoint of enabling the effect of the present invention to be further exhibited, the content proportion of the aromatic crosslinkable monomer (b) in the monomer component (M) is preferably equal to or less than 60% by weight, is more preferably 10% by weight to 60% by weight, is further preferably 20% by weight to 55% by weight, and is particularly preferably 30% by weight to 50% by weight. If the content proportion of the aromatic crosslinkable monomer (b) in the monomer component (M) falls within the above-described range, it is possible to cause the effect of the present invention to be further exhibited. If the content proportion of the aromatic crosslinkable monomer (b) in the monomer component (M) is excessively high, there is a concern that an unreacted reactive site may remain and adversely affect sufficient exhibition of the low dielectric characteristic. If the content proportion of the aromatic crosslinkable monomer (b) in the monomer component (M) is excessively low, the crosslinking density decreases, and there is thus a concern that the strength of the shell portion may be degraded.

The aromatic monofunctional monomer (a) may be of only one type or two or more types.

As the aromatic monofunctional monomer (a), it is possible to employ any suitable aromatic monofunctional monomer to the extent that it does not impair the effect of the present invention as long as it is a monofunctional aromatic monomer. Examples of such an aromatic monofunctional monomer (a) include styrene, ethylvinylbenzene, $\alpha$-methylstyrene, vinyltoluene, o-chlorostyrene, m-chlorostyrene, p-chlorostyrene, vinylbiphenyl, and vinylnaphthalene from the viewpoint of enabling the effect of the present invention to be further exhibited. From the viewpoint of enabling the effect of the present invention to be further exhibited and the viewpoint of reactivity, the aromatic monofunctional monomer (a) is preferably at least one kind selected from the group consisting of styrene and ethylvinylbenzene.

The aromatic crosslinkable monomer (b) may be of only one type or two or more types.

As the aromatic crosslinkable monomer (b), it is possible to employ any suitable aromatic crosslinkable monomer within a range in which the effect of the present invention is not impaired, provided that it is an aromatic monomer with crosslinkability. Examples of such an aromatic crosslinkable monomer (b) include divinylbenzene, divinylnaphthalene, and diallyl phthalate from the viewpoint of enabling the effect of the present invention to be further exhibited. From the viewpoint of enabling the effect of the present invention to be further exhibited and from the viewpoint of reactivity, the aromatic crosslinkable monomer (b) is preferably divinylbenzene.

The monomer component (M) may include a hydrophilic monofunctional monomer (c). The hydrophilic monofunctional monomer (c) may be of only one type or two or more types.

As the hydrophilic monofunctional monomer (c), any suitable hydrophilic monofunctional monomer may be employed within a range in which the effect of the present invention is not impaired. From the viewpoint of enabling the effect of the present invention to be further exhibited, the hydrophilic monofunctional monomer (c) is preferably represented by General Formula (1) or General Formula (2).

[C3]

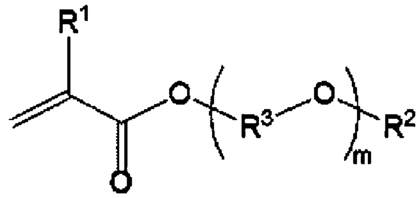

(1)

[C4]

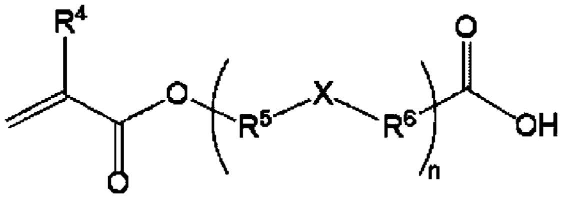

(2)

In General Formula (1), $R^1$ represents H or $CH_3$.

In General Formula (1), $R^2$ represents H, an alkyl group, or a phenyl group.

In General Formula (1), $R^3$ represents an alkanediyl group having 2 to 18 carbon atoms, is preferably an alkanediyl group having 2 to 8 carbon atoms, and is more preferably an alkanediyl group having 2 to 4 carbon atoms. The alkanediyl group may be linear, branched or cyclic.

Examples of the alkanediyl group include a methylene group, an ethane-1,1-diyl group, an ethane-1,2-diyl group, a propan-1,2-diyl group, a propan-2,2-diyl group, a propan-1,3-diyl group, a 2-methylpropane-1,3-diyl group, a butane-1, 3-diyl group, a butane-2,3-diyl group, and a butane-1,4-diyl group.

In General Formula (1), $R^3$-O is an oxyalkylene group having 2 to 18 carbon atoms, is preferably an oxyalkylene group having 2 to 8 carbon atoms, and is more preferably an oxyalkylene group having 2 to 4 carbon atoms. In a case where $R^3$-O is at least two or more kinds selected from an oxyethylene group, an oxypropylene group and an oxybutylene group, the addition form of $R^3$-O may be in any form among random addition, block addition, and alternating addition. Note that the addition form referred to herein means the form itself, and does not mean that it must be obtained through an addition reaction.

In General Formula (1), $R^3$-O is at least one kind selected from the group consisting of an oxyethylene group, an oxypropylene group, and an oxybutylene group (typically, an oxytetramethylene group) from the viewpoint of enabling the effect of the present invention to be further exhibited.

In General Formula (1), m represents an average number of moles added to the oxyalkylene group represented by $R^3$-O (which may be referred to as a "chain length"). m is a number of 1 to 100, is preferably a number of 1 to 40, is more preferably a number of 2 to 30, is further preferably a number of 3 to 20, is particularly preferably a number of 4 to 18, and is most preferably a number of 5 to 15. The effect of the present invention can be exhibited by m falling within the above-described range.

In General Formula (1), $R^3$ in the number of m are independent of each other. In a case where there are two or more kinds of $R^3$-O in General Formula (1), for example, in a case where $R^3$-O consists of an oxyethylene group ($C_2H_4O$) and an oxypropylene group ($C_3H_6O$), m is a total number of average number of moles added to each oxyalkylene group. Specifically, in a case where $-(R^3\text{-}O)_m-$ is $-[(C_2H_4O)_p(C_3H_6O)_q]-$ (as described above, the addition form may be any form among random addition, block addition, or alternate addition), for example, m = p + q.

Examples of the hydrophilic monofunctional monomers (c) represented by General Formula (1) include methoxypolyethylene glycol methacrylate, ethoxypolyethylene glycol methacrylate, propoxypolyethylene glycol methacrylate, butoxypolyethylene glycol methacrylate, hexaoxypolyethylene glycol methacrylate, octoxypolyethylene glycol polypropylene glycol methacrylate, lauroxy polyethylene glycol methacrylate, stearoxy polyethylene glycol methacrylate, phenoxy polyethylene glycol polypropylene glycol methacrylate, methoxy polyethylene glycol acrylate, polyethylene glycol monomethacrylate, polypropylene glycol monomethacrylate, polyethylene glycol propylene glycol monomethacrylate, polyethylene glycol tetramethylene glycol monomethacrylate, propylene glycol polybutylene glycol monomethacrylate, monoethylene glycol monoacrylate, and polypropylene glycol monoacrylate.

As the hydrophilic monofunctional monomer (c) represented by General Formula (1), a commercially available product can be employed. As such a commercially available product, for example, trade name "Blemmer" series

manufactured by NOF Corporation can be employed.

In General Formula (2), $R^4$ represents H or $CH_3$.

In General Formula (2), $R^5$ represents an alkanediyl group having 1 to 10 carbon atoms or an alkenediyl group having 2 to 10 carbon atoms. The number of carbon atoms in the above-described alkanediyl group is preferably 2 to 6, and is more preferably 2 to 4. The alkanediyl group may be linear, branched or cyclic. The number of carbon atoms in the alkenediyl group is preferably 2 to 6, and is more preferably 2 to 4. The alkenediyl group may be linear, branched, or cyclic.

In regard to $R^5$, examples of the alkanediyl group include the above-described examples. In regard to $R^5$, examples of the alkenediyl group include an ethene-1,2-diyl group, a 1-propene-1,3-diyl group, a 2-butene-1,4-diyl group, a 1-methyl-1-butene-1,4-diyl group, and a 2-cyclohexene-1,4-diyl group.

In General Formula (2), $R^6$ represents a single bond, an alkanediyl group having 1 to 10 carbon atoms, an alkenediyl group having 2 to 10 carbon atoms, or a phenylene group. The number of carbon atoms in the above-described alkanediyl group is preferably 2 to 6, and is more preferably 2 to 4. The alkanediyl group may be linear, branched or cyclic. The number of carbon atoms in the alkenediyl group is preferably 2 to 6, and is more preferably 2 to 4. The alkenediyl group may be linear, branched, or cyclic.

In regard to $R^6$, examples of the alkanediyl group include the above-described examples. In regard to $R^6$, examples of the alkenediyl group include the above-described examples.

In General Formula (2), X represents a single bond, an ester bond, an ether bond, or a carbonyl group. The ester bond may be a structure of $R^5$-O-CO-$R^6$, or may be a structure of $R^5$-CO-O-$R^6$.

In General Formula (2), n represents a number of 1 to 5, and $R^5$, the number of which is n, X, and $R^6$ are independent of each other.

Examples of the hydrophilic monofunctional monomer (c) represented by General Formula (2) include 2-methacryloyloxyethylsuccinic acid, 2-methacryloyloxyethylhexahydrophthalic acid, 2-methacryloyloxyethylmaleic acid, 2-acryloyloxyethylhexahydrophthalic acid, 2-acryloyloxyethylsuccinic acid, and 2-acryloyloxyethylphthalic acid.

As the hydrophilic monofunctional monomer (c) represented by General Formula (2), a commercially available product can be employed. As such a commercially available product, the product with the trade name of "Light Ester HO-MS(N)" manufactured by Kyoeisha Chemical Co., Ltd. can be employed, for example.

The SP value of the hydrophilic monofunctional monomer (c) is preferably 9.0 to 13.0, is more preferably 9.5 to 12.5, and is further preferably 10.0 to 12.0. If the hydrophilic monofunctional monomer (c) with the SP value falling within the above-described range is employed, it is possible to curb occurrence of agglomeration and coalescence of particles in the manufacturing, to reduce by-products of particles outside the specification, and to exhibit a more uniform low dielectric characteristic.

In regard to the SP value of the hydrophilic monofunctional monomer (c), a value can be used in a case where the value is described in a catalog or a document, or the SP value can be calculated as follows in a case where it is not described in a catalog or a document.

The SP value means a solubility parameter $\delta$ calculated by Equation (A) below using $\Delta F$ and a $\Delta v$ value of various atomic groups by Okitsu as described in Table 1 of "Adhesion" (Toshinao Okitsu, Polymer Publishing Society, vol. 40, No. 8 (1996), p. 342 to p. 350). Also, in a case of a mixture solvent and a copolymer, the SP value means a solubility parameter $\delta$ calculated by Equation (B) below.

$$\delta = \Sigma\Delta F/\Sigma\Delta v \qquad (A)$$

$$\delta_{mix} = \varphi_1\delta_1 + \varphi_2\delta_2 + \ldots + \varphi_n\delta_n \qquad (B)$$

In Equation (A), $\Delta F$ represents $\Delta F$ in Table 1 of "Adhesion", and $\Delta v$ represents a molar volume $\Delta v$ in Table 1 of "Adhesion". $\varphi$ denotes a mole fraction, where $\varphi_1 + \varphi_2 + \ldots + \varphi_n = 1$.

For example, the SP value of heptane as a solvent is determined as follows.

Heptane has two $-CH_3$ and five $-CH_2-$ as atomic groups. For each atomic group, $\Delta F$ and the $\Delta v$ value are obtained from Table 1 of "Adhesion".

$$\Sigma\Delta F = 205 \times 2 + 132 \times 5 = 1070$$

$$\Sigma\Delta v = 31.8 \times 2 + 16.5 \times 5 = 146.1$$

Therefore, $\delta_{hep}$ of heptane is obtained by Equation (A) as follows.

$$\delta_{hep} = \Sigma\Delta F/\Sigma\Delta v = 1070/146.1 = 7.32$$

In a case where a plurality of kinds of hydrophilic monofunctional monomer (c) are used, the SP value ($\delta_{mix}$) of the entire mixed hydrophilic monofunctional monomer (c) is calculated on the basis of the SP value (solubility parameter $\delta$) and the mole fraction in the manner described above.

From the viewpoint of enabling the effect of the present invention to be further exhibited, the content proportion of the hydrophilic monofunctional monomer (c) in the monomer component (M) is preferably equal to or less than 10% by weight, is more preferably equal to or less than 9.0% by weight, is further preferably equal to or less than 8.0% by weight, is further preferably equal to or less than 7.0% by weight, is further preferably 1.0% by weight to 7.0% by weight, is further preferably 1.5% by weight to 7.0% by weight, and is further preferably 2.0% by weight to 7.0% by weight. If the content proportion of the hydrophilic monofunctional monomer (c) in the monomer component (M) falls within the above-described range, it is possible to cause the effect of the present invention to be further exhibited.

The monomer component (M) preferably includes a reactive surfactant (d) having a vinyl group. The reactive surfactant (d) having a vinyl group may be of only one type or two or more types. If the monomer component (M) includes the reactive surfactant (d) having a vinyl group, the reactive surfactant (d) having a vinyl group is incorporated as a monomer component in the aromatic polymer (P1). Therefore, the surfactant can be reliably localized on the surface of the particle in suspension polymerization, and the surfactant effect can be improved. Therefore, it is possible to obtain an excellent surfactant effect even if the amount of use is reduced as compared with the case where a non-reactive surfactant having no vinyl group is used, to curb occurrence of agglomeration and coalescence of particles during manufacturing, to reduce by-products of particles outside the specification, and to exhibit a more uniform low dielectric characteristic.

Once the reactive surfactant (d) having a vinyl group is incorporated as a monomer component in the aromatic polymer (P1), the aromatic polymer (P1) includes a structural unit derived from the reactive surfactant (d) having a vinyl group. In other words, in a case where the reactive surfactant (d) having a vinyl group is represented by $CH_2 = C(R)\text{-}Z$ (R is H or $CH_3$), the aromatic polymer (P1) has a -Z group derived from the reactive surfactant (d) having a vinyl group.

For the hollow resin particle according to the embodiment of the present invention, it is preferable that the reactive surfactant (d) having a vinyl group be used as a surfactant in the manufacturing thereof, and that the amount of non-reactive surfactant having no vinyl group used be minimized. In other words, in the hollow resin particle according to the embodiment of the present invention, the content proportion of the reactive surfactant (d) having a vinyl group in the entire amount of surfactant used in the manufacturing thereof is preferably 50% by weight to 100% by weight, is more preferably 70% by weight to 100% by weight, is further preferably 90% by weight to 100% by weight, is particularly preferably 95% by weight to 100% by weight, and is most preferably 98% by weight to 100% by weight. In the hollow resin particle according to the embodiment of the present invention, it is possible to obtain an excellent surfactant effect even if the amount of use is reduced, to curb occurrence of agglomeration and coalescence of particles during manufacturing, to reduce by-products of particles outside the specification, and to exhibit a more uniform low dielectric characteristic as long as the content proportion of the reactive surfactant (d) having a vinyl group in the surfactant used in the manufacturing falls within the above-described range.

From the viewpoint of enabling the effect of the present invention to be further exhibited, the content proportion of the reactive surfactant (d) having a vinyl group in the monomer component (M) is preferably 0.05% by weight to 1.0% by weight, is more preferably 0.10% by weight to 0.50% by weight, and is further preferably 0.15% by weight to 0.45% by weight. If the content proportion of the reactive surfactant (d) having a vinyl group in the monomer component (M) falls within the above-described range, it is possible to further exhibit the effect of the present invention. If the content proportion of the reactive surfactant (d) having a vinyl group in the monomer component (M) is excessively high outside the above-described range, there is a concern that the uniform low dielectric characteristic cannot be exhibited. One of the reasons therefor is considered to be because the reactive surfactant (d) having a vinyl group includes an undeniable amount of metal residue in a case where the structure itself includes a metal element of course and even in a case where the structure itself does not include any metal element, and the containing of such metal residue is new knowledge discovered through the investigations of the present inventor to complete the present invention. On the other hand, if the content proportion of the reactive surfactant (d) having a vinyl group in the monomer component (M) is excessively low outside the above range, the surfactant effect cannot be sufficiently exhibited, agglomeration or coalescence of particles may occur during the manufacturing, particles outside the specification may be produced as by-products, variations may occur in low dielectric characteristics of the particles, and there is a concern that a uniform low dielectric characteristic cannot be exhibited. In this manner, it is possible to further exhibit the effect of the present invention, and particularly to exhibit a more uniform low dielectric characteristic by appropriately adjusting the content proportion of the reactive surfactant (d) having a vinyl group in the monomer component (M) within the above-described range in the present invention.

As the reactive surfactant (d) having a vinyl group, any suitable compound may be employed as long as the compound has a vinyl group and is capable of exhibiting a surfactant effect, within a range in which the effect of the present invention is not impaired. Examples of such a reactive surfactant (d) having a vinyl group include an anionic surfactant having a vinyl group and a nonionic surfactant having a vinyl group.

Examples of the anionic surfactants having a vinyl group include ammonium polyoxyethylene-1-(allyloxymethyl) alkyl ether sulfate esters, ammonium polyoxyethylene styrenated propenylphenyl ether sulfate esters, ammonium

polyoxyalkylene alkenyl ether sulfate, α-sulfo-ω-(1-alkoxymethyl-2-(2-propenyloxy)ethoxy)-poly(oxy-1,2-ethanediyl)ammonium, polyoxypropylene allyl ether phosphate esters, and bis(polyoxyethylene phenyl ether) methacrylate sulfate esters.

Examples of commercially available products of the ammonium polyoxyethylene-1-(allyloxymethyl) alkyl ether sulfate esters include trade name "AQUALON KH-10" and trade name "AQUALON KH-1025" (25% by weight aqueous solution of "AQUALON KH-10") manufactured by DKS CO. Ltd.

Examples of commercially available products of ammonium polyoxyethylene styrenated propenylphenyl ether sulfate esters include trade names "AQUALON AR-10", "AQUALON AR-20", and "AQUALON AR-1025" (25% by weight aqueous solution of "AQUALON AR-10") manufactured by DKS CO. Ltd.

Examples of commercially available products of the ammonium polyoxyalkylene alkenyl ether sulfate include trade name "LATEMUL PD-104" manufactured by Kao Corporation.

Examples of commercially available products of the α-sulfo-ω-(1-alkoxymethyl-2-(2-propenyloxy)ethoxy)-poly(oxy-1,2-ethanediyl)ammonium include trade names "ADEKA REASOAP SR-10" and "ADEKA REASOAP SR-20" manufactured by ADEKA Corporation.

Examples of commercially available products of the polyoxypropylene allyl ether phosphate esters include trade name "ADEKA REASOAP PP-70" manufactured by ADEKA Corporation.

Examples of commercially available products of the bis(polyoxyethylene phenyl ether) methacrylate sulfate esters include trade name "ANTOX MS-60" manufactured by Nippon Nyukazai Co., Ltd.

Examples of the nonionic surfactants having a vinyl group include polyoxyethylene styrenated propenylphenyl ether, polyoxyethylene-1-(allyloxymethyl) alkyl ether, and polyoxyalkylene alkenyl ether.

Examples of commercially available products of the polyoxyethylene styrenated propenylphenyl ether include trade names "AQUALON AN-10", "AQUALON AN-20", "AQUALON AN-30", and "AQUALON AN-5065" manufactured by DKS CO. Ltd.

Examples of commercially available products of the polyoxyethylene-1-(allyloxymethyl) alkyl ether include trade names "AQUALON KN-10", "AQUALON KN-20", "AQUALON KN-30", and "AQUALON KN-5065" manufactured by DKS CO. Ltd., "ADEKA REASOAP ER-10", "ADEKA REASOAP ER-20", "ADEKA REASOAP ER-30", and "ADEKA REASOAP ER-40" manufactured by ADEKA Corporation.

Examples of commercially available products of the polyoxyalkylene alkenyl ether include trade names "LATEMUL PD-420", "LATEMUL PD-430", and "LATEMUL PD-450" manufactured by Kao Corporation.

From the viewpoint of enabling the effect of the present invention to be further exhibited, the reactive surfactant (d) having a vinyl group is preferably an ammonium polyoxyethylene styrenated propenylphenyl ether sulfate ester.

From the viewpoint of enabling the effect of the present invention to be further exhibited, the total content proportion of the aromatic monofunctional monomer (a), the aromatic crosslinkable monomer (b), the hydrophilic monofunctional monomer (c) represented by General Formula (1) or General Formula (2), and the reactive surfactant (d) having a vinyl group in the monomer component (M) is preferably 80% by weight to 100% by weight, is more preferably 85% by weight to 100% by weight, is further preferably 90% by weight to 100% by weight, and is particularly preferably 95% by weight to 100% by weight.

The monomer component (M) may include any other suitable monomers within a range in which the effect of the present invention is not impaired. The other monomer may be of only one type or two or more types.

The shell portion may include, in addition to the aromatic polymer (P1), a non-crosslinkable polymer (P2). The non-crosslinkable polymer (P2) may be of only one type or two or more types. Since it is possible to promote phase separation of a polymerization oil droplets in the suspension polymerization and to easily form a uniform particle by including the non-crosslinkable polymer (P2), it is possible to exhibit an excellent low dielectric characteristic and a uniform low dielectric characteristic as a result.

As the non-crosslinkable polymer (P2), it is possible to employ any suitable non-crosslinkable polymer (P2) within a range in which the effect of the present invention is not impaired. As such a non-crosslinkable polymer (P2), a non-crosslinkable polymer having no carboxyl group is preferably used, and examples thereof include at least one kind selected from the group consisting of paraffin, polyolefin, a styrene-based polymer, and a (meth)acrylic acid ester polymer.

From the viewpoint of enabling the effect of the present invention to be further exhibited, the content proportion of the non-crosslinkable polymer (P2) in the shell portion is preferably 0% by weight to 40% by weight, is more preferably 3% by weight to 30% by weight, and is further preferably 5% by weight to 20% by weight. If the content proportion of the non-crosslinkable polymer (P2) in the shell portion is excessively high, there is a concern that an excellent low dielectric characteristic cannot be exhibited or a concern that a uniform low dielectric characteristic cannot be exhibited.

Examples of the paraffin include a paraffin wax and liquid paraffin.

Examples of polyolefins include polyethylene, polypropylene, and poly-α-olefin.

Examples of styrene polymers include polystyrene, styrene-acrylonitrile copolymers, and acrylonitrile-butadienestyrene copolymers.

Examples of the (meth)acrylic acid ester polymer include polymethyl (meth)acrylate, polyethyl (meth)acrylate,

polybutyl (meth)acrylate, polypropyl (meth)acrylate, a styrene-methyl (meth)acrylate copolymer, a styrene-ethyl (meth) acrylate copolymer, a styrene-butyl (meth)acrylate copolymer, and a styrene-propyl (meth)acrylate copolymer.

<<<<Method of Manufacturing Hollow Resin Particle>>>>

The hollow resin particle according to the embodiment of the present invention can be manufactured by any appropriate method as long as the effect of the present invention is not impaired. From the viewpoint of enabling the effect of the present invention to be further exhibited, the hollow resin particle according to the embodiment of the present invention can be preferably manufactured by a method of manufacturing the hollow resin particle according to the embodiment of the present invention.

The method of manufacturing the hollow resin particle according to the embodiment of the present invention is a method of manufacturing a hollow resin particle including a shell portion and a hollow part surrounded by the shell portion.

In the method of manufacturing the hollow resin particle according to the embodiment of the present invention, an oil phase and an aqueous phase are mixed and stirred to prepare a suspension, and suspension polymerization of a monomer component (M) included in the suspension is performed. The monomer component (M) described here is synonymous with the monomer component (M) in the section of <<Shell Portion>> described above and means that the aromatic polymer (P1) is obtained through a reaction of the monomer component (M). In other words, in the method of manufacturing the hollow resin particle according to the embodiment of the present invention, the monomer component (M) means the total monomer components included in the suspension, that is, a total of a monomer component in the oil phase to be subjected to the suspension polymerization and the monomer component in the aqueous phase.

Typically, the oil phase typically includes an aromatic monofunctional monomer (a) and an aromatic crosslinkable monomer (b). For the aromatic monofunctional monomer (a) and the aromatic crosslinkable monomer (b), the above description in the section of <<Shell Portion>> can be incorporated.

In the method of manufacturing the hollow resin particle according to the embodiment of the present invention, the content proportion of the aromatic monofunctional monomer (a) in the monomer component (M) is equal to or greater than 30% by weight, is preferably 30% by weight to 80% by weight, is more preferably 35% by weight to 70% by weight, and is further preferably 40% by weight to 60% by weight. If the content proportion of the aromatic monofunctional monomer (a) in the monomer component (M) falls within the above-described range, it is possible to cause the effect of the present invention to be further exhibited.

In the method of manufacturing the hollow resin particle according to the embodiment of the present invention, the content proportion of the aromatic crosslinkable monomer (b) in the monomer component (M) is equal to or less than 60% by weight, is preferably 10% by weight to 60% by weight, is more preferably 20% by weight to 55% by weight, and is further preferably 30% by weight to 50% by weight. If the content proportion of the aromatic crosslinkable monomer (b) in the monomer component (M) falls within the above-described range, it is possible to cause the effect of the present invention to be further exhibited. If the content proportion of the aromatic crosslinkable monomer (b) in the monomer component (M) is excessively high, an unreacted reactive site may remain, and there is a concern that sufficient exhibition of the low dielectric characteristic may be adversely affected. If the content proportion of the aromatic crosslinkable monomer (b) in the monomer component (M) is excessively low, the crosslinking density decreases, and there is a concern that the strength of the shell portion may be degraded.

The oil phase may include a hydrophilic monofunctional monomer (c). For the hydrophilic monofunctional monomer (c), the above description in the section of <<Shell Portion>> can be incorporated.

From the viewpoint of enabling the effect of the present invention to be further exhibited, the content proportion of the hydrophilic monofunctional monomer (c) in the monomer component (M) is preferably equal to or less than 10% by weight, is more preferably equal to or less than 9.0% by weight, is further preferably equal to or less than 8.0% by weight, is further preferably equal to or less than 7.0% by weight, is further preferably 1.0% by weight to 7.0% by weight, is further preferably 1.5% by weight to 7.0% by weight, and is further preferably 2.0% by weight to 7.0% by weight in the method of manufacturing the hollow resin particle according to the embodiment of the present invention. If the content proportion of the hydrophilic monofunctional monomer (c) in the monomer component (M) falls within the above-described range, it is possible to further exhibit the effect of the present invention.

The oil phase may include an organic solvent. The organic solvent may be of only one type or two or more types. As the organic solvent, any appropriate organic solvent can be employed as long as the effect of the present invention is not impaired. Examples of such an organic solvent preferably include organic solvents having a boiling point of less than 100°C. When an organic solvent having a boiling point of less than 100°C is used as the organic solvent, it becomes easy to remove the solvent from the hollow part of a hollow resin particle to be obtained, and the production cost can be reduced.

Examples of the organic solvent having a boiling point of less than 100°C include heptane, hexane, cyclohexane, methyl acetate, ethyl acetate, methyl ethyl ketone, chloroform, and carbon tetrachloride.

As the amount of the organic solvent used, any appropriate amount used can be employed in a range in which the effect of the present invention is not impaired. Such an amount of the organic solvent used is, for example, 10 parts by

weight to 300 parts by weight with respect to 100 parts by weight of monomer component in the oil phase.

The oil phase may include a polymerization initiator. The polymerization initiator may be of only one type or two or more types. As the polymerization initiator, any appropriate polymerization initiator can be employed as long as the effect of the present invention is not impaired.

The polymerization initiator preferably has a 10-hour half-life temperature of equal to or less than 90°C. If such a polymerization initiator is used, it is possible to completely decompose the polymerization initiator remaining in the hollow resin particle.

Examples of such a polymerization initiator include: organic peroxides such as lauroyl peroxide, benzoyl peroxide, orthochlorobenzoyl peroxide, orthomethoxybenzoyl peroxide, 3,5,5-trimethylhexanoyl peroxide, t-butylperoxy-2-ethylhexanoate, and di-t-butyl peroxide; and azo-based compounds such as 2,2'-azobisisobutyronitrile, 1,1'-azobiscyclohexanecarbonitrile, and 2,2'-azobis(2,4-dimethylvaleronitrile).

As the amount of polymerization initiator used, any appropriate amount used can be employed within a range in which the effect of the present invention is not impaired. Such an amount of polymerization initiator used is, for example, 0.1 parts by weight to 5 parts by weight with respect to 100 parts by weight of the monomer component (M) (the total of the monomer component in the oil phase to be subjected to the suspension polymerization and the monomer component in the aqueous phase) included in the suspension.

The oil phase may include a non-crosslinkable polymer (P2). The non-crosslinkable polymer (P2) may be of only one type or two or more types. For the non-crosslinkable polymer (P2), the above description in the section of <<Shell Portion>> can be incorporated.

As the amount of non-crosslinkable polymer (P2) used, it is possible to employ any suitable amount of use within a range in which the effect of the present invention is not impaired. Such an amount of non-crosslinkable polymer (P2) used is 0 parts by weight to 67 parts by weight, is more preferably 3 parts by weight to 43 parts by weight, and is further preferably 5 parts by weight to 25 parts by weight with respect to 100 parts by weight of monomer component (M) (the total of the monomer component in the oil phase to be subjected to the suspension polymerization and the monomer component in the aqueous phase) included in the suspension, for example. If the amount of non-crosslinkable polymer (P2) used is excessively large, there is a concern that an excellent low dielectric characteristic cannot be exhibited or a concern that a uniform low dielectric characteristic cannot be exhibited.

The oil phase may contain any other appropriate components in addition to the above-described components as long as the effect of the present invention is not impaired.

Typically, the aqueous phase includes a reactive surfactant (d) having a vinyl group. For the reactive surfactant (d) having a vinyl group, the above description in the section of <<Shell Portion>> can be incorporated.

In the method of manufacturing the hollow resin particle according to the embodiment of the present invention, the content proportion of reactive surfactant (d) having a vinyl group in the monomer component (M) is 0.05% by weight to 1.0% by weight, is preferably 0.10% by weight to 0.50% by weight, and is more preferably 0.15% by weight to 0.45% by weight. If the content proportion of the reactive surfactant (d) having a vinyl group in the monomer component (M) falls within the above-described range, the effect of the present invention may be further exhibited. If content proportion of the reactive surfactant (d) having a vinyl group in the monomer component (M) is excessively high outside the above-described range, there is a concern that a uniform low dielectric characteristic cannot be exhibited. One of reasons therefor is considered to be because the reactive surfactant (d) having a vinyl group includes an undeniable amount of metal residue in a case where the structure itself includes a metal element of course and even in a case where the structure itself does not include any metal element, and the containing of such metal residue is new knowledge discovered through the investigations of the present inventor to complete the present invention, similarly to the description in the section of <<Shell Portion>>. On the other hand, if the content proportion of the reactive surfactant (d) having a vinyl group in the monomer component (M) is excessively low outside the above range, the surfactant effect cannot be sufficiently exhibited, agglomeration or coalescence of particles may occur during the manufacturing, particles outside the specification may be produced as by-products, variations may occur in low dielectric characteristics of the particles, and there is a concern that a uniform low dielectric characteristic cannot be exhibited. In this manner, it is possible to further exhibit the effect of the present invention, and particularly to exhibit a more uniform low dielectric characteristic by appropriately adjusting the content proportion of the reactive surfactant (d) having a vinyl group in the monomer component (M) within the above-described range in the present invention.

Typically, the aqueous phase includes a water-based medium. Examples of the water-based medium include water and a mixed medium of water and a lower alcohol (such as methanol or ethanol). The water is preferably at least one kind selected from the group consisting of ion-exchange water and distilled water.

The aqueous phase may contain any other appropriate components in addition to the above-described components as long as the effect of the present invention is not impaired.

In the method of manufacturing the hollow resin particle according to the embodiment of the present invention, the oil phase and the aqueous phase as described above are mixed and stirred to prepare a suspension, and suspension polymerization of the monomer component (M) contained in the suspension is carried out.

As a method for mixing the oil phase and the aqueous phase, any appropriate method can be employed provided that the suspension polymerization can be performed as long as the effect of the present invention is not impaired.

The suspension is prepared by mixing and stirring the oil phase and the aqueous phase and dispersing the oil phase in the aqueous phase. For the dispersion of the oil phase in the aqueous phase, any appropriate dispersion method can be employed provided that it is possible to make the oil phase present in the aqueous phase in a liquid droplet form as long as the effect of the present invention is not impaired. Such a dispersion method is typically a dispersion method using a homogenizer, and examples thereof include an ultrasound homogenizer, a high-pressure homogenizer, and the like.

As a method of the suspension polymerization, it is possible to employ any suitable method within a range in which the effect of the present invention is not impaired.

As the polymerization temperature, any appropriate polymerization temperature can be employed provided that the temperature is suitable for the suspension polymerization as long as the effect of the present invention is not impaired. Such a polymerization temperature is, for example, 30°C to 95°C.

As a polymerization time, any appropriate polymerization time can be employed provided that the time is suitable for the suspension polymerization as long as the effect of the present invention is not impaired. Such a polymerization time is preferably one hour to 20 hours.

Post-heating that is preferably performed after polymerization is a suitable treatment to obtain a hollow resin particle having a high degree of perfection.

As the temperature of the post-heating that is preferably performed after polymerization, any appropriate temperature can be employed as long as the effect of the present invention is not impaired. Such a temperature of the post-heating is preferably 50°C to 120°C.

As the time of the post-heating that is preferably performed after polymerization, any appropriate time can be employed as long as the effect of the present invention is not impaired. Such a time of the post-heating is preferably one hour to 10 hours.

Distillation, solvent removal, classification, cleaning, drying, and the like are performed on the slurry obtained by the suspension polymerization as necessary, thereby obtaining a hollow resin particle.

<<<<Applications of Hollow Resin Particle>>>>

The hollow resin particle according to the embodiment of the present invention can be employed in various uses. From the viewpoint of being able to better utilize the effect of the present invention, the hollow resin particles according to the embodiment of the present invention are suitable for semiconductor members, and can typically be suitably used in a resin composition for a semiconductor member. In addition to the above-described application to the resin composition for a semiconductor member, the hollow resin particle according to the embodiment of the present invention can also be applied to applications in which the effect of the present invention can be utilized, such as a paint composition, a thermal insulation resin composition, a light diffusion resin composition, and a light diffusion film.

<<Resin Composition for Semiconductor Member>>

The hollow resin particles according to the embodiment of the present invention can achieve a low dielectric constant and a low dielectric loss tangent, can exhibit excellent heat resistance, and can thus be suitably used in a resin composition for a semiconductor member.

A resin composition for a semiconductor member according to the embodiment of the present invention contains the hollow resin particle according to the embodiment of the present invention.

A semiconductor member means a member constituting a semiconductor, and examples thereof include a semiconductor package and a semiconductor module. In the present specification, the resin composition for a semiconductor member means a resin composition that is used for semiconductor members.

A semiconductor package is composed of at least one component selected from a mold resin, an underfill material, a mold underfill material, a die bond material, a prepreg for a semiconductor package substrate, a metal-clad laminated plate for a semiconductor package substrate, and a build-up material for a printed circuit board for a semiconductor package, with an IC chip as an essential constituent member.

A semiconductor module is composed of at least one component selected from a prepreg for a printed circuit board, a metal-clad laminated plate for a printed circuit board, a build-up material for a printed circuit board, a solder resist material, a coverlay film, an electromagnetic wave shielding film, and an adhesive sheet for a printed circuit board, with a semiconductor package as an essential constituent member.

<<Paint Composition>>

The hollow resin particles according to the embodiment of the present invention can be suitably used in a paint

composition because they can impart an excellent appearance to paint films containing them.

A paint composition according to an embodiment of the present invention contains the hollow resin particles according to the embodiment of the present invention.

The paint composition according to the embodiment of the present invention preferably contains at least one selected from a binder resin and a UV curable resin. The binder resin may be of only one type or two or more types. The UV curable resin may be of only one type or two or more types.

As binder resins, any appropriate binder resins can be employed within the range in which the effect of the present invention is not impaired. Examples of such binder resins include resins that are soluble in organic solvents or water and emulsion-type aqueous resins that can be dispersed in water. Specific examples of binder resins include acrylic resins, alkyd resins, polyester resins, polyurethane resins, chlorinated polyolefin resins, and amorphous polyolefin resins.

As the UV curable resin, any suitable UV curable resin can be employed within a range in which the effect of the present invention is not impaired. Examples of such a UV curable resin include a polyfunctional (meth)acrylate resin and a polyfunctional urethane acrylate resin, a polyfunctional (meth)acrylate resin is preferably used, and a polyfunctional (meth)acrylate resin having three or more (meth)acryloyl groups in one molecule is more preferably used. Specific examples of the polyfunctional (meth)acrylate resin having three or more (meth)acryloyl groups in one molecule include trimethylolpropane tri(meth)acrylate, trimethylolethane tri(meth)acrylate, 1,2,4-cyclohexane tetra(meth)acrylate, pentaglycerol triacrylate, pentaerythritol tetra(meth)acrylate, pentaerythritol tri(meth)acrylate, dipentaerythritol triacrylate, dipentaerythritol pentaacrylate, dipentaerythritol tetra(meth)acrylate, dipentaerythritol hexa(meth)acrylate, tripentaerythritol triacrylate, and tripentaerythritol hexaacrylate.

In a case where the paint composition according to the embodiment of the present invention includes at least one kind selected from the binder resin and the UV curable resin, any suitable content proportion thereof can be employed as the content proportion thereof according to the purpose. Typically, the content of the hollow resin particle according to the embodiment of the present invention is preferably 5% by weight to 50% by weight, is more preferably 10% by weight to 50% by weight, and is further preferably 20% by weight to 40% by weight with respect to the total amount of the at least one kind selected from the binder resin (in terms of the solid content in a case of an emulsion-type aqueous resin) and the UV curable resin and the hollow resin particle according to the embodiment of the present invention.

In a case where the UV curable resin is used, a photopolymerization initiator is preferably used together. As the photopolymerization initiator, any suitable photopolymerization initiator can be employed within a range in which the effect of the present invention is not impaired. Examples of such a photopolymerization initiator include acetophenones, benzoins, benzophenones, phosphine oxides, ketals, $\alpha$-hydroxyalkylphenones, $\alpha$-aminoalkylphenones, anthraquinones, thioxanthones, azo compounds, peroxides (described in Japanese Patent Application Publication No. 2001-139663 or the like), 2,3-dialkyldione compounds, disulfide compounds, fluoroamine compounds, aromatic sulfoniums, onium salts, borate salts, active halogen compounds, and $\alpha$-acyl oxime esters.

The paint composition according to the embodiment of the present invention may contain a solvent. The solvent may be of only one type or two or more types. If the paint composition according to the embodiment of the present invention contains a solvent, any appropriate content proportion can be employed according to the purpose.

As solvents, any appropriate solvents can be employed within the range in which the effect of the present invention is not impaired. Such solvents are preferably solvents that can dissolve or disperse binder resins or UV curable resins. Examples of such solvents for oil-based paints include hydrocarbon-based solvents such as toluene and xylene; ketone-based solvents such as methyl ethyl ketone and methyl isobutyl ketone; ester-based solvents such as ethyl acetate and butyl acetate; and ether-based solvents such as dioxane, ethylene glycol diethyl ether, and ethylene glycol monobutyl ether, and examples thereof for water-based paints include water and alcohols.

The paint composition according to the embodiment of the present invention may be diluted to adjust viscosity as necessary. As diluents, any appropriate diluents can be employed according to the purpose. Examples of such diluents include the aforementioned solvents. The diluents may be of only one type or two or more types.

The paint composition according to the embodiment of the present invention may contain, as necessary, other components, for example, a coated surface adjusting agent, a fluidity adjuster, an ultraviolet absorber, a light stabilizer, a curing catalyst, an extender pigment, a coloring pigment, a metal pigment, a mica powder pigment, and dyes.

In a case of forming a paint film using the paint composition according to the embodiment of the present invention, any appropriate coating methods can be employed according to the purpose. Examples of such coating methods include a spray coating method, a roll coating method, a brush coating method, a coating reverse roll coating method, a gravure coating method, a die coating method, a comma coating method, and a spray coat method.

In a case where a coating film is formed using the paint composition according to the embodiment of the present invention, any suitable forming method can be employed according to the purpose. Such a forming method includes, for example, a method of forming the coating film by producing an applied film by applying the paint composition to an arbitrary application surface of the base material, drying the applied film, and then curing the applied film as needed. Examples of the base material include metal, wood, glass, plastic (polyethylene terephthalate (PET), polycarbonate (PC), an acrylic resin, and triacetyl cellulose (TAC)).

<<Thermal Insulation Resin Composition>>

The hollow resin particles according to the embodiment of the present invention can be suitably used in a thermal insulation resin composition because they can impart excellent thermal insulation to a paint film containing them. The paint film containing the hollow resin particles according to the embodiment of the present invention can exhibit excellent reflectance within a range of wavelengths from ultraviolet light to near-infrared light.

A thermal insulation resin composition according to an embodiment of the present invention contains the hollow resin particles according to the embodiment of the present invention.

The thermal insulation resin composition according to the embodiment of the present invention preferably contains at least one selected from a binder resin and a UV curable resin. For binder resins and UV curable resins, the description of the aforementioned paint composition can be used.

The thermal insulation resin composition according to the embodiment of the present invention may contain a solvent. For solvents, the description of the aforementioned paint composition can be used.

The thermal insulation resin composition according to the embodiment of the present invention may be diluted to adjust viscosity as necessary. For diluents, the description of the aforementioned paint composition can be used.

The thermal insulation resin composition according to the embodiment of the present invention may contain, as necessary, other components, for example, a coated surface adjusting agent, a fluidity adjuster, an ultraviolet absorber, a light stabilizer, a curing catalyst, an extender pigment, a coloring pigment, a metal pigment, a mica powder pigment, and dyes.

For coating methods and formation methods when forming a paint film using the thermal insulation resin composition according to the embodiment of the present invention, the description of the aforementioned paint composition can be used.

<<Light Diffusion Resin Composition>>

The hollow resin particles according to the embodiment of the present invention can be suitably used in a light diffusion resin composition because they can impart excellent light diffusibility to a paint film containing them.

A light diffusion resin composition according to an embodiment of the present invention contains the hollow resin particles according to the embodiment of the present invention.

The light diffusion resin composition according to the embodiment of the present invention preferably contains at least one selected from a binder resin and a UV curable resin. For binder resins and UV curable resins, the description of the aforementioned paint composition can be used.

The light diffusion resin composition according to the embodiment of the present invention may contain a solvent. For solvents, the description of the aforementioned paint composition can be used.

The light diffusion resin composition according to the embodiment of the present invention may be diluted to adjust viscosity as necessary. For diluents, the description of the aforementioned paint composition can be used.

The light diffusion resin composition according to the embodiment of the present invention may contain, as necessary, other components, for example, a coated surface adjusting agent, a fluidity adjuster, an ultraviolet absorber, a light stabilizer, a curing catalyst, an extender pigment, a coloring pigment, a metal pigment, a mica powder pigment, and dyes.

For coating methods and formation methods when forming a paint film using the light diffusion resin composition according to the embodiment of the present invention, the description of the aforementioned paint composition can be used.

<<Light Diffusion Film>>

The hollow resin particles according to the embodiment of the present invention can also be suitably used in a light diffusion film because they can impart excellent light diffusibility to a film with a paint film containing them.

A light diffusion film according to an embodiment of the present invention contains the hollow resin particles according to the embodiment of the present invention.

The light diffusion film according to the embodiment of the present invention includes a base material and a light diffusion layer formed from the light diffusion resin composition according to the embodiment of the present invention. The light diffusion layer may or may not be the outermost layer of the light diffusion film. The light diffusion film according to the embodiment of the present invention may include any other appropriate layers according to the purpose. Examples of such other layers include a protective layer, a hard coat layer, a planarization layer, a high refractive index layer, an insulating layer, a conductive resin layer, a conductive metal particulate layer, a conductive metal oxide particulate layer, and a primer layer.

Examples of the base material include metal, wood, glass, a plastic film, a plastic sheet, a plastic lens, a plastic

panel, a cathode ray tube, a fluorescent display tube, and a liquid crystal display panel. Examples of plastic constituting the plastic film, the plastic sheet, the plastic lens, and the plastic panel include polyethylene terephthalate (PET), polycarbonate (PC), an acrylic resin, and triacetyl cellulose (TAC) .

## Examples

Hereinafter, the present invention will be described specifically with reference to examples, but the present invention is not limited to these examples. Unless otherwise specified, "parts" means "parts by weight" and "%" means "% by weight".

<Average Particle Diameter>

The Z-average particle diameter of a hollow resin particle or a particle was measured using dynamic light scattering, and the measured Z-average particle diameter was used as the average particle diameter of the hollow resin particle or the particle obtained.

In other words, the resulting slurry-like hollow resin particle or particle was diluted with ion-exchange water, a water dispersion adjusted to 0.1% by weight was irradiated with laser light, and the intensity of scattered light scattered from the hollow resin particle or the particle was measured in a time change in units of microseconds. Then, the detected scattering intensity distribution attributable to the hollow resin particle or the particle was fitted to a normal distribution, and the Z-average particle diameter of the hollow resin particle or the particle was obtained by a cumulant analysis method for calculating the average particle diameter.

The Z-average particle diameter can be easily measured by a commercially available particle diameter measuring apparatus. In the following examples and comparative examples, the Z-average particle diameter was measured using a particle diameter measuring apparatus (Zetasizer Nano ZS manufactured by Malvern Panalytical Ltd.). Usually, a commercially available particle diameter measuring apparatus is equipped with data analysis software such that the Z-average particle diameter can be calculated by the data analysis software automatically analyzing measurement data.

<TEM Measurement: Observation of Presence/Absence and Shape of Hollow Resin Particle and Particle Hollow>

The hollow resin particle or the particle as a dried powder was subjected to surface treatment (10 Pa, 5 mA, 10 seconds) using an "Osmium Coater Neoc-Pro" coating device manufactured by Meiwafosis Co., Ltd. Next, the hollow resin particle or the particle was observed using a transmission electron microscope (TEM H-7600 manufactured by Hitachi High-Tech Corporation), and the presence/absence of hollowing and the shape of the hollow resin particle or the particle were confirmed. At this time, images were taken by setting an acceleration voltage of 80 kV and setting a magnification of 5000 times or 10000 times. Note that in a case where a hollowness rate is calculated, it is only necessary to calculate the hollowness rate as an average value of 100 particles on the basis of length measurement results observed by TEM.

<Measurement of Amount of Metal Residue>

The amount of metal residue was measured as follows.

(Measurement Sample)

0.5 g of hollow resin particles was accurately weighed into a washed 50 mL polyethylene container. 1 mL of washing ethanol was added to sufficiently mix and disperse the particle. Furthermore, 50 mL of ion-exchange water was poured thereto, and the mixture was sufficiently mixed. After ultrasonic cleaning and extraction was conducted for about 10 minutes, the mixture was left still in a constant temperature bath at 60°C for 60 minutes. The slurry after being left still was filtered through an aqueous 0.20 μm chromato-disk to be used as a measurement sample.

(Measurement Method)

The amount of metal residue in the measurement sample was measured under the following conditions. The amount of metal residue was obtained from a calibration curve produced in advance. The amount of metal residue was calculated from the following equation. The amount of metal residue (ppm) = measured metal element concentration (μg/mL) $\times$ 51 (mL)/amount of sample (g). Also, the lower limit of quantitation was 1 ppm, and when the measurement result was equal to or less than the lower limit of quantitation, 1 ppm which was the lower limit of quantitation was used as the measurement result.

(ICP Measurement Conditions)

Measurement device = "ICPE-9000", manufactured by Shimadzu Corporation, multitype ICP emission spectrometer
Measurement element = Ca, K, Li, Mg, Na
Observation direction = axial direction
High-frequency output = 1.20 kw
Carrier flow amount = 0.7 L/min
Plasma flow amount = 10.0 L/min
Auxiliary flow amount = 0.6 L/min
Exposure time = 30 seconds
Standard solution for calibration curve = about 10 mg/L of each of "XSTC-13" general-purpose mixed standard solution of 31-element mixture (base 5% $HNO_3$) and about 10 mg/L of each of "XSTC-8" general-purpose mixed standard solution of 13-element mixture (base $H_2O$/trace HF) available from SPEX in the U.S.A.

<Evaluation of Dielectric Characteristic>

[Evaluation of Dielectric Characteristic of Hollow Resin Particle]

The dielectric characteristic of the hollow resin particle was measured using a dielectric constant measuring apparatus (ADMS01Nc series) manufactured by AET. The dielectric loss tangent (Df) of the hollow resin particle was calculated on the basis of the perturbation theory by means of a resonator at a frequency of 10 GHz, in a measurement environment at 23°C, and at relative humidity of 51±1%.

Furthermore, an F value, which was an index of uniformity of the dielectric loss tangent Df, was calculated. The F value was calculated by measuring the dielectric loss tangent Df of the hollow resin particle at five measurement points, and calculating the maximum value of Df ($Df_{max}$), the minimum value of Df ($Df_{min}$), and the average value of Df ($Df_{av}$), and calculating the equation of F value = ($Df_{max}$ - $Df_{min}$)/$Df_{av}$.

A smaller F value means that variations in dielectric loss tangent Df are smaller and means that uniform low dielectric characteristic can be exhibited. Based on the obtained F value, evaluation was conducted by the following criteria.

The F value was less than 0.15: A
The F value was equal to or greater than 0.15 and less than 0.25: B
The F value was equal to or greater than 0.25 and less than 0.35: C
The F value was equal to or greater than 0.35: D

[Evaluation of Dielectric Characteristic of Film]

The dielectric characteristic of the film was measured using a dielectric constant measuring apparatus (ADMS01Nc series) manufactured by AET. The dielectric loss tangent (Df) of the film was calculated on the basis of the perturbation theory by means of a resonator at a frequency of 10 GHz, in a measurement environment at 23°C, and at relative humidity of 51±1%.

The measurement result of the dielectric loss tangent was represented as a relative proportion (%) with the measurement value of a film containing no particles taken as 100%. This relative proportion is preferably less than 85%, is more preferably equal to or less than 80%, is still more preferably equal to or less than 75%, and is particularly preferably equal to or less than 70%.

Furthermore, an F value, which is an index of uniformity of the dielectric loss tangent Df, was calculated. The F value was calculated by measuring the dielectric loss tangent Df of the film at five measurement points, calculating the maximum value of Df ($Df_{max}$), the minimum value of Df ($Df_{min}$), and the average value of Df ($Df_{av}$), and calculating the equation of F value = ($Df_{max}$ - $Df_{min}$)/$Df_{av}$.

A smaller F value means that variations in dielectric loss tangent Df are smaller and means that uniform low dielectric characteristic can be exhibited. Based on the obtained F value, evaluation was conducted by the following criteria.

The F value was less than 0.15: A
The F value was equal to or greater than 0.15 and less than 0.25: B
The F value was equal to or greater than 0.25 and less than 0.35: C

The F value was equal to or greater than 0.35: D

<Raw Materials Used>

The raw materials used were as follows.

[Aromatic Monofunctional Monomer (a)]

- Styrene

[Aromatic Crosslinkable Monomer (b)]

- Divinylbenzene (DVB) 810 (Nippon Steel Chemical & Material Co., Ltd., an 81% by weight containing product, 19% by weight of ethylvinylbenzene (EVB))

[Hydrophilic Monofunctional Monomer (c)]

- Compound corresponding to General Formula (1): polyethylene glycol propylene glycol monomethacrylate (trade name "Blemmer 50PEP-300" manufactured by NOF Corporation; in General Formula (1), $R^1 = CH_3$, $R^2 = H$, $(R^3\text{-}O)_m = [(C_2H_4O)_{3.5}(C_3H_6O)_{2.5}]$, random addition form, SP value = 10.5)
- Compound corresponding to General Formula (1): methoxypolyethylene glycol monomethacrylate (trade name "Blemmer PME-100" manufactured by NOF Corporation; in General Formula (1): $R^1 = CH_3$, $R^2 = CH_3$, $(R^3\text{-}O)_m = [(C_2H_4O)_2]$, SP value = 9.3)
- Compound corresponding to General Formula (1): polyethylene glycol monoacrylate (trade name "Blemmer AE-90U" manufactured by NOF Corporation; in General Formula (1), $R^1 = H$, $R^2 = H$, $(R^3\text{-}O)_m = [(C_2H_4O)_2]$, SP value = 12.8)
- Compound corresponding to General Formula (2): 2-methacryloyloxyethyl succinic acid (trade name "Light Ester HO-MS(N)" manufactured by Kyoeisha Chemical Co., Ltd.; in General Formula (2), $R^4 = CH_3$, $R^5 = CH_2CH_2$, $R^6 = CH_2CH_2$, X = -O-C(=O)-, n = 1, SP value = 10.2)

[Reactive Surfactant (d) Having Vinyl Group]

- Polyoxyethylene styrenated propenylphenyl ether sulfate ammonium salt (trade name: "AQUALON AR-10" manufactured by DKS CO. Ltd.)
- $\alpha$-sulfo-$\omega$-(1-alkoxymethyl-2-(2-propenyloxy)ethoxy)-poly(oxy-1,2-ethanediyl)ammonium (trade name: "ADEKA REASOAP SR-10" manufactured by ADEKA Corporation)

[Non-reactive Surfactant Having No Vinyl Group]

- Di-2-ethylhexyl sodium sulfosuccinate (trade name: "RAPISOL A-80" manufactured by NOF Corporation, pure content of 80% by weight)

[Non-crosslinkable Polymer (P2)]

- Paraffin wax (trade name: "VYBAR260" manufactured by Nucera Solutions)

[Organic Solvent]

- Heptane

[Polymerization Initiator]

- Lauroyl peroxide (trade name: "PEROYL L" manufactured by NOF Corporation)

[Water-based Medium]

- Ion-exchange water

[Example 1]

After an oil phase and an aqueous phase were adjusted according to the compositions shown in Table 1, the oil phase and the aqueous phase were mixed and treated using a homo mixer (trade name: T.K. Homo mixer MARKII 2.5 type manufactured by Primix Corporation) at a rotational speed of 8000 rpm for 10 minutes, thereby obtaining an emulsion (mixture solution). Subsequently, the emulsion was subjected to emulsification treatment under conditions of an inlet treatment pressure of 20 Mpa and an outlet pressure of 10 Mpa using a high-pressure emulsifier NVR (model "EM055-P20-0600-Exp" manufactured by Yoshida Kikai Co., Ltd.), thereby producing a suspension. The resulting suspension was heated at 60°C for 10 hours, the temperature was raised to 90°C, and the heating was conducted for 3 hours, thereby performing suspension polymerization.

The organic solvent was removed from the slurry obtained by suspension polymerization through distillation, and large-diameter particles were classified and removed by a wire net of 500 mesh (aperture of 25 μm), thereby obtaining a slurry including the hollow resin particle.

The slurry including the hollow resin particle was spraydried under the apparatus conditions described below using a spray dryer (manufactured by Sakamoto Giken, machine name: "Spray Dryer", model: "Atomizer take-up system", model number: "TRS-3WK"), thereby obtaining a hollow resin particle (1). It was possible to confirm through TEM measurement that the hollow resin particle (1) was a hollow particle with a single-hollow structure.

<Device Conditions>

Feeding speed of slurry including hollow resin particle: 25 mL/min Rotation number of atomizer: 12000 rpm
Airflow: 2 $m^3$/min
Inlet temperature (the inlet temperature of the inlet included in the spray dryer such that the slurry including the hollow resin particle was spray-introduced thereinto): 185°C
Outlet temperature (the temperature of the outlet included in the spray dryer such that the hollow resin particle was discharged): 70°C

Results are shown in Table 1.

[Example 2]

A hollow resin particle (2) was obtained similarly to Example 1 other than that sodium nitrite with the composition shown in Table 1 was added to the aqueous phase in Example 1 as shown in Table 1. It was possible to confirm through TEM measurement that the hollow resin particle (2) was a hollow particle with a single-hollow structure.

Results are shown in Table 1.

[Example 3]

A hollow resin particle (3) was obtained similarly to Example 1 other than that "Light Ester HO-MS(N)" was used instead of "Blemmer 50PEP-300" as the hydrophilic monofunctional monomer (c) as shown in Table 1. It was possible to confirm through TEM measurement that the hollow resin particle (3) was a hollow particle with a single-hollow structure.
Results are shown in Table 1.

[Example 4]

A hollow resin particle (4) was obtained similarly to Example 1 other than that the amount of "AQUALON AR-10" was changed to 1.5 parts by weight as shown in Table 1. It was possible to confirm through TEM measurement that the hollow resin particle (4) was a hollow particle with a single-hollow structure.
Results are shown in Table 1.

[Example 5]

A hollow resin particle (5) was obtained similarly to Example 1 other than that the amount of "AQUALON AR-10" was changed to 5.0 parts by weight as shown in Table 1. It was possible to confirm through TEM measurement that the hollow resin particle (5) was a hollow particle with a single-hollow structure.
Results are shown in Table 1.

[Example 6]

A hollow resin particle (6) was obtained similarly to Example 1 other than that 3.5 parts by weight of "ADEKA REASOAP SR-10" was used instead of 3.0 parts by weight of "AQUALON AR-10" as the reactive surfactant (d) as shown in Table 1. It was possible to confirm through TEM measurement that the hollow resin particle (6) was a hollow particle with a single-hollow structure.
Results are shown in Table 1.

[Example 7]

A hollow resin particle (7) was obtained similarly to Example 1 other than that "Blemmer PME-100" was used instead of "Blemmer 50PEP-300" as the hydrophilic monofunctional monomer (c) as shown in Table 1. It was possible to confirm through TEM measurement that the hollow resin particle (7) was a hollow particle with a single-hollow structure.
Results are shown in Table 1.

[Example 8]

A hollow resin particle (8) was obtained similarly to Example 1 other than that "Blemmer AE-90U" was used instead of "Blemmer 50PEP-300" as the hydrophilic monofunctional monomer (c) as shown in Table 1. It was possible to confirm through TEM measurement that the hollow resin particle (8) was a hollow particle with a single-hollow structure.
Results are shown in Table 1.

[Comparative Example 1]

A hollow resin particle (C1) was obtained similarly to Example 1 other than that sodium nitrite with a composition shown in Table 2 was added to the aqueous phase in Example 1 as shown in Table 2. It was possible to confirm through TEM measurement that the hollow resin particle (C1) was a hollow particle with a single-hollow structure.
Results are shown in Table 2.

[Comparative Example 2]

A hollow resin particle (C2) was obtained similarly to Example 1 other than that sodium nitrite with a composition shown in Table 2 was added to the aqueous phase in Example 1 as shown in Table 2. It was possible to confirm through TEM measurement that the hollow resin particle (C2) was a hollow particle with a single-hollow structure.
Results are shown in Table 2.

[Comparative Example 3]

A hollow resin particle (C3) was obtained similarly to Example 1 other than that the same amount of "RAPISOL A-80" which was a non-reactive surfactant that did not have a vinyl group in terms of pure content (the pure content of 3.0 g since the amount of use was 3.75 g and the pure content was 80% by weight) was used instead of "AQUALON AR-10" which was a reactive surfactant (d) having a vinyl group as shown in Table 2. It was possible to confirm through TEM measurement that the hollow resin particle (C3) was a hollow particle with a single-hollow structure.

Results are shown in Table 2.

[Comparative Example 4]

A hollow resin particle (C4) was obtained similarly to Example 1 other than that the amount of used "AQUALON AR-10" which was a reactive surfactant (d) having a vinyl group was increased as shown in Table 2. It was possible to confirm through TEM measurement that the hollow resin particle (C4) was a hollow particle with a single-hollow structure.

Results are shown in Table 2.

[Comparative Example 5]

A hollow resin particle (C5) was obtained similarly to Example 1 other than that the amount of used "Blemmer 50PEP-300" which was the hydrophilic monofunctional monomer (c) was increased and instead, the amounts of the aromatic monofunctional monomer (a) and the aromatic crosslinkable monomer (b) were reduced as shown in Table 2. It was possible to confirm through TEM measurement that the hollow resin particle (C5) was a hollow particle with a single-hollow structure.

Results are shown in Table 2.

[Table 1]

| | | | | | Example 1 | Example 2 | Example 3 | Example 4 | Example 5 | Example 6 | Example 7 | Example 8 |
|---|---|---|---|---|---|---|---|---|---|---|---|---|
| Oil phase | (1) | Aromatic monofunctional monomer (a) (part by weight) | Styrene | | 306 | 306 | 306 | 306 | 306 | 306 | 306 | 306 |
| | | | DVB810 | EVB | 94 | 94 | 94 | 94 | 94 | 94 | 94 | 94 |
| | (2) | Aromatic crosslinkable monomer (b) (part by weight) | | DVB | 400 | 400 | 400 | 400 | 400 | 400 | 400 | 400 |
| | (3) | Hydrophilic monofunctional monomer (c) (part by weight) | Light Ester HO-MS (N) | | 0 | 0 | 50 | 0 | 0 | 0 | 0 | 0 |
| | | | Blemmer 50PEP-300 | | 50 | 50 | 0 | 50 | 50 | 50 | 0 | 0 |
| | | | Blemmer PME-100 | | 0 | 0 | 0 | 0 | 0 | 0 | 50 | 0 |
| | | | Blemmer AE-90U | | 0 | 0 | 0 | 0 | 0 | 0 | 0 | 50 |
| | (4) | Non-crosslinkable polymer (P2) (part by weight) | VYBAR260 | | 150 | 150 | 150 | 150 | 150 | 150 | 150 | 150 |
| | (5) | Organic solvent (part by weight) | Heptane | | 400 | 400 | 400 | 400 | 400 | 400 | 400 | 400 |
| | (6) | Polymerization initiator (part by weight) | Lauroyl peroxide | | 16 | 16 | 16 | 16 | 16 | 16 | 16 | 16 |
| Aqueous phase | (7) | Water-based medium (part by weight) | Ion-exchange water | | 4000 | 4000 | 4000 | 4000 | 4000 | 4000 | 4000 | 4000 |
| | (8) | Reactive surfactant (d) (part by weight) | AQUALON AR-10 | | 3.0 | 3.0 | 3.0 | 1.5 | 5.0 | 0 | 3.0 | 3.0 |
| | | | ADEKA REASOAP SR-10 | | 0 | 0 | 0 | 0 | 0 | 3.5 | 0 | 0 |
| | (9) | Non-reactive surfactant (part by weight) | RAPISOL A-80 | | 0 | 0 | 0 | 0 | 0 | 0 | 0 | 0 |
| | (10) | Metal component (part by weight) | Sodium nitrite | | 0 | 0.005 | 0 | 0 | 0 | 0 | 0 | 0 |

(continued)

| | | | Example 1 | Example 2 | Example 3 | Example 4 | Example 5 | Example 6 | Example 7 | Example 8 |
|---|---|---|---|---|---|---|---|---|---|---|
| Proportion | Content portion in Monomer component (M) ((1)+(2)+(3)+(8)+(9))(weight proportion) | (1) Aromatic monofunctional monomer (a) | 46.9% | 46.9% | 46.9% | 47.0% | 46.8% | 46.9% | 46.9% | 46.9% |
| | | (2) Aromatic crosslinkable monomer (b) | 46.9% | 46.9% | 46.9% | 47.0% | 46.8% | 46.9% | 46.9% | 46.9% |
| | | (3) Hydrophilic monofunctional monomer (c) | 5.9% | 5.9% | 5.9% | 5.9% | 5.8% | 5.9% | 5.9% | 5.9% |
| | | (8) Reactive surfactant (d) | 0.35% | 0.35% | 0.35% | 0.18% | 0.58% | 0.41% | 0.35% | 0.35% |
| | | (9) Non-reactive surfactant | 0.00% | 0.00% | 0.00% | 0.00% | 0.00% | 0.00% | 0.00% | 0.00% |
| | Addition proportion (4) non-crosslinkable polymer (P2) with respect to 100 parts by weight of monomer component (M) ((1)+(2)+(3)+(8)+(9)) (part by weight) | | 17.58% | 17.58% | 17.58% | 17.62% | 17.54% | 17.57% | 17.58% | 17.58% |
| Evaluation | Average particle diameter | | 453 nm | 444 nm | 443 nm | 445 nm | 450 nm | 479 nm | 461 nm | 439 nm |
| | Hollow structure | | Single hollow | Single hollow | Single hollow | Single hollow | Single hollow | Single hollow | Single hollow | Single hollow |
| | Amount of metal residue | | 24ppm | 29ppm | 22ppm | 19ppm | 28ppm | 21ppm | 28ppm | 29ppm |
| | Dielectric loss tangent Df | | 0.0029 | 0.0039 | 0.0027 | 0.0024 | 0.0041 | 0.0030 | 0.0048 | 0.0049 |
| | F value | | A | B | A | A | B | A | B | B |
| | | | 0.12 | 0.24 | 0.10 | 0.14 | 0.24 | 0.13 | 0.30 | 0.30 |

[Table 2]

| | | | | | Comparative Example 1 | Comparative Example 2 | Comparative Example 3 | Comparative Example 4 | Comparative Example 5 |
|---|---|---|---|---|---|---|---|---|---|
| Oil phase | (1) | Aromatic monofunctional monomer (a) (part by weight) | Styrene | | 306 | 306 | 306 | 306 | 286 |
| | | | DVB810 | EVB | 94 | 94 | 94 | 94 | 84 |
| | (2) | Aromatic crosslinkable monomer (b) (part by weight) | | DVB | 400 | 400 | 400 | 400 | 360 |
| | (3) | Hydrophilic monofunctional monomer (c) (part by weight) | Light Ester HO-MS (N) | | 0 | 0 | 0 | 0 | 0 |
| | | | Blemmer 50PEP-300 | | 50 | 50 | 50 | 50 | 120 |
| | | | Blemmer PME-100 | | 0 | 0 | 0 | 0 | 0 |
| | | | Blemmer AE-90U | | 0 | 0 | 0 | 0 | 0 |
| | (4) | Non-crosslinkable polymer (P2) (part by weight) | VYBAR260 | | 150 | 150 | 150 | 150 | 150 |
| | (5) | Organic solvent (part by weight) | Heptane | | 400 | 400 | 400 | 400 | 400 |
| | (6) | Polymerization initiator (part by weight) | Lauroyl peroxide | | 16 | 16 | 16 | 16 | 16 |
| Aqueous phase | (7) | Water-based medium (part by weight) | Ion-exchange water | | 4000 | 4000 | 4000 | 4000 | 4000 |
| | (8) | Reactive surfactant (d) (part by weight) | AQUALON AR-10 | | 3.0 | 3.0 | 0 | 10.0 | 3.0 |
| | | | ADEKA REASOAP SR-10 | | 0 | 0 | 0 | 0 | 0 |
| | (9) | Non-reactive surfactant (part by weight) | RAPISOL A-80 | | 0 | 0 | 3.0 | 0 | 0 |
| | (10) | Metal component (part by weight) | Sodium nitrite | | 0.015 | 0.060 | 0 | 0 | 0 |
| Proportion | Content portion in Monomer component (M) ((1)+(2)+(3)+(8)+(9))(weight proportion) | | (1) Aromatic monofunctional monomer (a) | | 46.9% | 46.9% | 46.9% | 46.5% | 43.4% |
| | | | (2) Aromatic crosslinkable monomer (b) | | 46.9% | 46.9% | 46.9% | 46.5% | 42.2% |
| | | | (3) Hydrophilic monofunctional monomer (c) | | 5.9% | 5.9% | 5.9% | 5.8% | 14.1% |
| | | | (8) Reactive surfactant (d) | | 0.35% | 0.35% | 0.00% | 1.16% | 0.35% |
| | | | (9) Non-reactive surfactant | | 0.00% | 0.00% | 0.35% | 0.00% | 0.00% |
| | Addition proportion (4) non-crosslinkable polymer (P2) with respect to 100 parts by weight of monomer component (M) ((1)+(2)+(3)+(B)+(9))(part by weight) | | | | 17.58% | 17.58% | 17.58% | 17.44% | 17.58% |

(continued)

| | | Comparative Example 1 | Comparative Example 2 | Comparative Example 3 | Comparative Example 4 | Comparative Example 5 |
|---|---|---|---|---|---|---|
| Evaluation | Average particle diameter | 466nm | 460nm | 433nm | 457nm | 477nm |
| | Hollow structure | Single hollow | Single hollow | Single hollow | Single hollow | Single hollow |
| | Amount of metal residue | 44ppm | 88ppm | 233ppm | 61ppm | 32ppm |
| | Dielectric loss tangent Df | 0.0055 | 0.0075 | 0.0089 | 0.0067 | 0.0072 |
| | F value | C | D | D | D | D |
| | | 0.33 | 0.44 | 0.55 | 0.49 | 0.35 |

[Example 9]

A film to which the hollow resin particle (1) obtained in Example 1 was added was produced as follows, and a dielectric characteristic of the thus obtained film was evaluated.

0.6 g of hollow resin particle (1) obtained in Example 1 and 10 g of ultra-high heat resistant polyimide varnish SPIXAREA HR002 (manufactured by Somar Corporation) were subjected to defoaming agitation using a planetary stirring and defoaming machine ("Mazerustar KK-250" manufactured by Kurabo Industries, Ltd.), and a mixture for evaluation was produced. The mixture for evaluation was applied to a glass plate having a thickness of 5 mm using an applicator set to a wet thickness of 250 μm, and then the solvent was removed by heating it at 120°C for 10 minutes, at 180°C for 180 minutes, and at 270°C for 60 minutes, followed by cooling it to room temperature, thereby obtaining a film including the particle.

Results are shown in Table 3.

[Example 10]

The hollow resin particle (2) obtained in Example 2 instead of the hollow resin particle (1) obtained in Example 1 was used to thereby obtain a film including the particle similarly to Example 9.

Results are shown in Table 3.

[Comparative Example 6]

The hollow resin particle (C1) obtained in Comparative Example 1 instead of the hollow resin particle (1) obtained in Example 1 was used to thereby obtain a film including the particle similarly to Example 9.

Results are shown in Table 3.

[Comparative Example 7]

The hollow resin particle (C2) obtained in Comparative Example 2 instead of the hollow resin particle (1) obtained in Example 1 was used to thereby obtain a film including the particle similarly to Example 9.

Results are shown in Table 3.

[Table 3]

| | Example 9 | Example 10 | Comparative Example 6 | Comparative Example 7 | Film not including particle |
|---|---|---|---|---|---|
| | Film including hollow resin particle (1) obtained in Example 1 | Film including hollow resin particle (2) obtained in Example 2 | Film including hollow resin particle (C1) obtained in Comparative Example 1 | Film including hollow resin particle (C2) obtained in Comparative Example 2 | |
| Dielectric loss tangent (relative proportion %) | 68 | 78 | 85 | 87 | 100 |
| F value | A | B | D | D | N/A |
| | 0.13 | 0.22 | 0.35 | 0.41 | |

[Industrial Applicability]

The hollow resin particle according to the embodiment of the present invention and the hollow resin particle obtained by the manufacturing method according to the embodiment of the present invention can be applied to various applications such as a resin composition for a semiconductor member, a paint composition, a thermal insulation resin composition, a light diffusion resin composition, and a light diffusion film.

## Claims

1. A hollow resin particle comprising: a shell portion; and a hollow part surrounded by the shell portion,

   wherein an amount of metal residue is equal to or less than 30 ppm,
   a dielectric loss tangent Df at a frequency of 10 GHz is equal to or less than 0.0050, and
   an F value which is an index of uniformity of the dielectric loss tangent Df is equal to or less than 0.30.

2. The hollow resin particle according to claim 1, wherein the dielectric loss tangent Df is equal to or less than 0.0030.

3. The hollow resin particle according to claim 1, wherein the F value is equal to or less than 0.15.

4. The hollow resin particle according to claim 1, wherein an average particle diameter is 0.1 μm to 10.0 μm.

5. The hollow resin particle according to claim 1, wherein the shell portion includes an aromatic polymer (P1) obtained through a reaction of a monomer component (M) including an aromatic monofunctional monomer (a) and an aromatic crosslinkable monomer (b).

6. The hollow resin particle according to claim 5, wherein a content proportion of the aromatic polymer (P1) in the shell portion is 60% by weight to 100% by weight.

7. The hollow resin particle according to claim 5, wherein a content proportion of the aromatic crosslinkable monomer (b) in the monomer component (M) is equal to or less than 60% by weight.

8. The hollow resin particle according to claim 5, wherein the monomer component (M) includes a hydrophilic monofunctional monomer (c).

9. The hollow resin particle according to claim 8, wherein the hydrophilic monofunctional monomer (c) is represented by General Formula (1) or General Formula (2),

   [C1]

   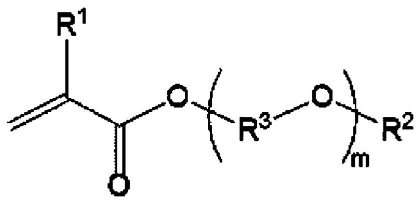

   (1)

   in General Formula (1), $R^1$ represents H or $CH_3$, $R^2$ represents H, an alkyl group, or a phenyl group, $R^3$ represents an alkanediyl group having 2 to 18 carbon atoms, m is an average number of addition moles of an oxyalkylene group represented by $R^3$-O and represents a number of 1 to 100, $R^3$, the number of which is m, are independent of each other,

   [C2]

   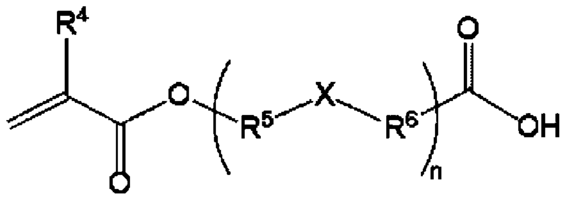

   (2)

   in General Formula (2), $R^4$ represents H or $CH_3$, $R^5$ represents an alkanediyl group having 1 to 10 carbon atoms or an alkenediyl group having 2 to 10 carbon atoms, $R^6$ represents a single bond, an alkanediyl group having 1 to 10

carbon atoms, an alkenediyl group having 2 to 10 carbon atoms, or a phenylene group, X represents a single bond, an ester bond, an ether bond, or a carbonyl group, n represents a number of 1 to 5, and $R^3$, the number of which is n, X, and $R^6$ are independent of each other.

**10.** The hollow resin particle according to claim 5, wherein the monomer component (M) includes a reactive surfactant (d) having a vinyl group.

**11.** The hollow resin particle according to claim 10, wherein a content proportion of the reactive surfactant (d) having a vinyl group in the monomer component (M) is 0.10% by weight to 1.0% by weight.

**12.** The hollow resin particle according to claim 11, wherein a content proportion of the reactive surfactant (d) having a vinyl group in the monomer component (M) is 0.10% by weight to 0.50% by weight.

**13.** The hollow resin particle according to claim 10, wherein the reactive surfactant (d) having a vinyl group is an ammonium polyoxyethylene styrenated propenylphenyl ether sulfate ester.

**14.** The hollow resin particle according to claim 1, wherein the shell portion includes a non-crosslinkable polymer (P2).

**15.** The hollow resin particle according to claim 14, wherein a content proportion of the non-crosslinkable polymer (P2) in the shell portion is 0% by weight to 40% by weight.

**16.** The hollow resin particle according to any one of claims 1 to 15 used in a resin composition for a semiconductor member.

**17.** The hollow resin particle according to any one of claims 1 to 15 used in a paint composition.

**18.** The hollow resin particle according to any one of claims 1 to 15 used in a thermal insulation resin composition.

**19.** The hollow resin particle according to any one of claims 1 to 15 used in a light diffusion resin composition.

**20.** The hollow resin particle according to any one of claims 1 to 15 used in a light diffusion film.

**21.** A resin composition for a semiconductor member, comprising:
the hollow resin particle according to any one of claims 1 to 15.

**22.** A paint composition comprising:
the hollow resin particle according to any one of claims 1 to 15.

**23.** A thermal insulation resin composition comprising:
the hollow resin particle according to any one of claims 1 to 15.

**24.** A light diffusion resin composition comprising:
the hollow resin particle according to any one of claims 1 to 15.

**25.** A light diffusion film comprising:
the hollow resin particle according to any one of claims 1 to 15.

**26.** A method of manufacturing a hollow resin particle including a shell portion and a hollow part surrounded by the shell portion, the method comprising:

preparing a suspension by mixing and stirring an oil phase and an aqueous phase and subjecting the suspension to suspension polymerization of a monomer component (M) contained in the suspension,
wherein the oil phase includes an aromatic monofunctional monomer (a) and an aromatic crosslinkable monomer (b),
the aqueous phase includes a reactive surfactant (d) having a vinyl group,
a content proportion of the aromatic monofunctional monomer (a) in the monomer component (M) is equal to or greater than 30% by weight,
a content proportion of the aromatic crosslinkable monomer (b) in the monomer component (M) is equal to or less

than 60% by weight, and
a content proportion of the reactive surfactant (d) having a vinyl group in the monomer component (M) is 0.10% by weight to 1.0% by weight.

## INTERNATIONAL SEARCH REPORT

International application No.
**PCT/JP2024/029223**

**A. CLASSIFICATION OF SUBJECT MATTER**

***C08J 3/12***(2006.01)i; ***C08F 212/00***(2006.01)i; ***C08F 255/00***(2006.01)i; ***C09D 7/65***(2018.01)i; ***C09D 201/00***(2006.01)i; ***H01L 23/29***(2006.01)i; ***H01L 23/31***(2006.01)i
FI: C08J3/12 Z; C08F212/00; C08F255/00; C09D7/65; C09D201/00; H01L23/30 R

According to International Patent Classification (IPC) or to both national classification and IPC

**B. FIELDS SEARCHED**

Minimum documentation searched (classification system followed by classification symbols)

C08J3/00-3/28; C08J99/00; C08F212/00; C08F255/00; C09D7/65; C09D201/00; H01L23/29; H01L23/31

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2022-096298 A (SEKISUI PLASTICS CO., LTD.) 29 June 2022 (2022-06-29) claim 1, paragraph [0071], example 13 | 1-26 |
| Y | WO 2021/039798 A1 (SEKISUI PLASTICS CO., LTD.) 04 March 2021 (2021-03-04) paragraphs [0017]-[0018], [0031] | 1-26 |
| A | WO 2023/074651 A1 (ZEON CORPORATION) 04 May 2023 (2023-05-04) claims, examples | 1-26 |
| A | JP 2000-313818 A (JSR CORP.) 14 November 2000 (2000-11-14) claims, paragraph [0009], examples | 1-26 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 October 2024** | **29 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/029223**

| Patent document cited in search report | Publication date (day/month/year) | Patent family member(s) | Publication date (day/month/year) |
|---|---|---|---|
| JP 2022-096298 A | 29 June 2022 | WO 2022/130938 A1 | |
| | | TW 202235153 A | |
| | | CN 116685611 A | |
| | | KR 10-2023-0096101 A | |
| WO 2021/039798 A1 | 04 March 2021 | US 2022/0306784 A1 | |
| | | paragraphs [0039]-[0041], [0072]-[0075] | |
| | | EP 4023681 A1 | |
| | | KR 10-2022-0024724 A | |
| WO 2023/074651 A1 | 04 May 2023 | CN 118119445 A | |
| | | KR 10-2024-0088903 A | |
| | | TW 202334261 A | |
| JP 2000-313818 A | 14 November 2000 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6513273 B
- WO 2022107674 A
- JP 2022096298 A
- JP 2001139663 A


### Non-patent literature cited in the description


- **TOSHINAO OKITSU**. *Polymer Publishing Society*, 1996, vol. 40 (8), 342-350